# EUROPEAN PATENT APPLICATION

(11) **EP 0 821 414 A1**
(43) Date of publication of application: **28.01.1998**
(21) Application number: 97305270.7
(22) Date of filing: 15.07.1997
(51) Int. Cl.: H01L 27/115, H01L 27/105, H01L 21/8247

(54) **CMOS compatible EPROM device**

(30) Priority: 23.07.1996 US 685294
(71) Applicant: LUCENT TECHNOLOGIES INC., Murray Hill, New Jersey 07974-0636 (US)
(72) Inventor: O'Connor, Kevin John, Lebanon, NJ 08833 (US)
(74) Representative: Buckley, Christopher Simon Thirsk

(57) **Abstract**

The specification describes a CMOS compatible process for EPROM manufacture and the resulting EPROM device. The cladding layer used in CMOS processing is utilized in a dual role as a strap for the complementary doped polysilicon gate layer, and as the primary or control gate in the EPROM array. The only additional step in the processing is to form an intergate dielectric to isolate the polysilicon gate on the EPROM side prior to depositing the cladding layer. Using this technique the height of the gate stack not significantly greater than the height of the CMOS gate structures thus resulting in a reduced IC profile.

## Description

### Field of the Invention

The invention relates to electrically programmable read-only memories ( EPROMs ) and to methods for their manufacture.

### Background of the Invention

Semiconductor non-volatile read-only memories have been implemented in a variety of forms most of which are variations of the traditional insulated gate field effect transistor structure. These implementations use a floating gate, typically a polysilicon gate, as the memory element. They are typically programmed electrically and may be erased either electrically or with UV light. Devices that are electrically erasable are frequently referred to as EEPROMs for Electrically Erasable Programmable Read Only Memory. Some refer to these devices as EAROMs for Electrically Alterable Read Only Memory. Memory arrays that are erasable with UV light are generally referred to as UV-EPROMS. Devices in which all memory cells can be erased at once are referred to as "flash" EPROMS or "flash" EEPROMs. There is also a class of devices that are similar to gate array devices which are permanently programmed and are referred to as OTP or One Time Programmable devices.

The invention that is described herein is applicable to all these read only memories and for the purpose of this description any reference to EPROM should be considered generic to these classes of devices. The invention is directed to a device feature that all these devices share, i.e. a floating gate structure that forms the basic memory element and imparts the non-volatile quality to the device.

A typical EPROM consists of a memory array, usually of NMOS devices, with CMOS devices for the drive, logic and sense circuits. Consequently the overall technology used in EPROMs, as in DRAMs, is CMOS technology. Thus it is important that any new development in EPROM device design be compatible with CMOS processing.

A feature of CMOS technology that is particularly relevant to this invention is the use of a cladding layer over the polysilicon gate level layer to prevent lateral migration and interdiffusion between the n-doped and p-doped regions of the polysilicon gate layer. The cladding layer is sometimes referred to as a "strap" since it shunts the p-n junction that forms at the interface between the complementary doped gate layer. The cladding layer is typically composed of TiN although other materials, notably other refractory metal nitrides or refractory metal silicides, may be used. The use of a TiN strapping layer is described by Pfiester et al in "A Cobalt Salicide CMOS Process with TiN-Strapped Polysilicon Gates", *IEEE Electron Device Letters,* Vol. 12, No. 6, June 1991.

Many of the earliest versions of EPROMs used overlapping polysilicon electrodes, separated by a grown oxide, as the floating element. This structure was derived from the charge coupled device technology and was essentially a dual (side-by-side) gate device. The series conventional MOSFET made overerase more manageable, among other features. While successful, the dual gate approach consumed considerable chip area. As VLSI technology developed, with major focus on high device packing density, stacked gate structures emerged. These structures used two polysilicon layers stacked vertically and separated by an isolating oxide. These stacked structures conserved chip area but the increased vertical stack size of the memory element, with shrinking horizontal dimensions, complicated device processing. Until now it was assumed that a floating gate required either increased chip area or a substantial increase in device profile (stack height).

### Statement of the Invention

I have developed a new processing approach and floating gate structure that neither increases chip area or substantially increases the height of the gate stack over that of a conventional n- or p-type MOSFET. It is a variation of the conventional stacked polysilicon gate structure but uses the conventional cladding layer as the top gate electrode. This dual role for the cladding layer eliminates the second poly layer and thereby reduces the height of the gate stack. Cladding layers are typically present in CMOS devices for preventing cross diffusion between n-doped and p-doped polysilicon and for reducing the sheet resistance of the polysilicon. Compatibility with conventional CMOS processing is a major advantage of the invention.

### Brief description of the Drawing

Figure 1 is a schematic representation of a the basic floating polysilicon gate stacked structure and an MOS transistor from an adjacent CMOS circuit;
Figure 2 is a schematic representation, similar to that of Figure 1, showing the same circuit elements constructed according to the invention;
Figures 3-12 are illustrations of process steps used in the fabrication of the generic stacked gate structure of Figure 2.

### Detailed Description

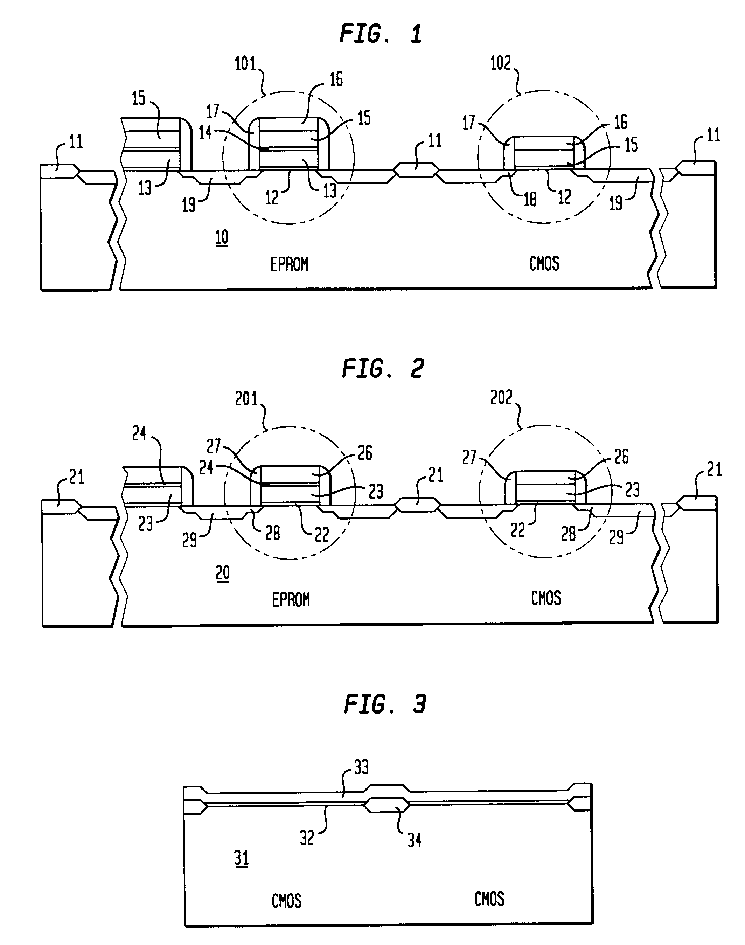

With reference to Figure 1, the basic stacked floating gate structure that is a generic element in stacked gate EPROM devices is shown alongside a conventional CMOS device, which in this case an n-channel or NMOS transistor. ( It will be understood that no attempt has been made to draw the elements in these Figures to scale.) While a n-channel transistor is shown it will be appreciated by those skilled in the art that a p-channel or PMOS device could also be represented. The n-channel device was chosen for illustration because the memory device in this embodiment is an n-channel device. It also better illustrates the processing compatibility which is a feature of the invention as will be described later.

In Figure 1 the EEPROM device is shown at 101 and the CMOS transistor at 102. The devices are typical of the many in a EPROM or CMOS array as suggested by the breaks in the Figure. The substrate shown at 10, the field oxide shown at 11, the gate dielectric shown at 12, the floating gate poly shown at 13, and the conventional gate level poly shown at 15, are standard structural features in silicon IC technology. The gate dielectric is grown SiO₂ with a typical thickness of the order of 20 to 200 Angstroms. The poly layers 13 and 15 are typically CVD layers of polysilicon of the order of 500-1000 nm in thickness. The poly gate layer is degeneratively doped to decrease sheet resistance and eliminate depletion effects. Here the usual practice is to dope the polysilicon gates overlying the n-channel devices with arsenic to render it n-type and the polyslicon gates overlying the p-channel devices with a p-type dopant such as boron. This complementary doping of the polysilicon gate layer is designed to match the work functions of the gates to those of the transistor channel and has been found to be helpful to the ultimate device performance. However, the high diffusion propensity of dopants in polysilicon results in significant lateral movement of the impurities during subsequent processing steps, notably the source/drain implant drive steps and process anneals. Under typical processing conditions the dopants will interdiffuse to an extent which reduces and even eliminates the objective of complementary doping. Various techniques have been proposed to avoid lateral diffusion, including attempts at reducing thermal processing of the wafer. However, the most effective remedy to date is the use of a cladding layer deposited over the polysilicon gate after the complementary doping implant step. It has been found that the presence of the cladding layer reduces the tendency of the dopants to diffuse laterally and maintains the desired complementary doping profiles. The cladding layer is shown at 16 on the n-channel transistor 102. A significant added advantage of the cladding layer is that it shunts the p-n junction formed at the interface between the complementary doped regions of the gate poly layer. The cladding layer typically has a thickness comparable to the thickness of the poly layers.

In a conventional stacked EEPROM device the lower poly gate (13) is isolated to form the capacitively coupled memory plate. It is isolated with a second gate dielectric, shown at 14 in Figure 1, and a second poly gate shown at 15. The interlevel dielectric 14 typically has a thickness larger than the thickness of the primary gate dielectric 12 to allow for programming the floating gate. The floating gate is "written" using a voltage higher than the operating voltage of the primary or control gate. The floating gate is charged by tunneling carriers either from the transistor substrate ( channel ), from the overlying polysilicon electrode, or the source or drain. Alternatively it may be programmed by hot electron injection from the channel, source, or drain. Discharging or erasing the charge from the floating gate typically involves these same processes. Combinations of the mechanisms have also been used. A more recent technique for programming EEPROMS is Channel Induced Secondary Electron Injection ( CISEI ) described and claimed in my copending patent application Serial No. 08/450,179 (Bude - O'Connor - Pinto Case 1-8-5). The polysilicon gate 15 is the functional gate used to switch the EEPROM device 101. Titanium nitride cladding layer 16 is shown overlying gate 15. Both structures 101 and 102 in Figure 1 are completed with the standard sidewall spacers 17, lightly doped source/drain 18 and source/drain implants 19.

As will be evident from an inspection of Figure 1 the gate stack for the memory device 101 is significantly higher than the height of the gate for the CMOS element 102.

Turning to the structure of Figure 2 here the n-channel CMOS transistor is shown at 202 and is the same, element for element, as device 102 of Figure 1. The gate dielectric is shown at 22, with polysilicon gate 23, cladding layer 26, sidewall spacers 27, lightly doped source/drain 28 and source/drain implants 29. The EPROM device 201 however is changed, according to the invention, to eliminate the second polysilicon layer ( 15 of Figure 1 ). In this structure the cladding layer 26 is deposited directly over the interlevel dielectric layer 24.

By comparing Figures 1 and 2 it is evident that the height of the gate stack for the EPROM device is substantially reduced. In fact it is only higher by the thickness of the relatively thin interlevel dielectric layer 24. As mentioned in connection with Figure 1, this layer is typically a few hundred angstroms in thickness.

It will be recognized by those skilled in the art that the processing sequence for forming the device 201 of Figure 2 is not only less complex than the process for forming the device 101 of Figure 1 but is hardly more than required for device 202. The step of forming the dielectric layer 24 is the only substantial addional step to the CMOS process. It requires only a single added mask step, and no critical alignment steps.

The process sequence will be described with reference to Figure 3-12. In this description, as well as in the description of Figures 1 and 2, various conventional device elements and conventional processing steps have been omitted for simplicity. For example, in the structures of Figures 1 and 2 it will be understood that these devices are finished with the usual deposited interlevel dielectrics, multiple patterned metal interconnect levels, and passivating layer. It is also understood that only a portion of the overall device is shown to illustrate the inventive contribution. Likewise in the processing sequence about to be described, conventional steps for preparing the substrate, e.g. cleaning, CMOS tub formation, field oxide growth, etc., are within the skill of the art and need not be described in detail. The description is directed mainly at the channel area of the devices shown in Figure 2 and particularly the gate structures.

In Figure 3, the gate dielectric 32 is grown to a thickness of 40-60 Angstroms, over p-type silicon substrate 31. Gate polysilicon layer 33 is deposited by CVD at 550°C to a thickness of 500-2000 Angstroms. The standard field oxide is shown at 34.

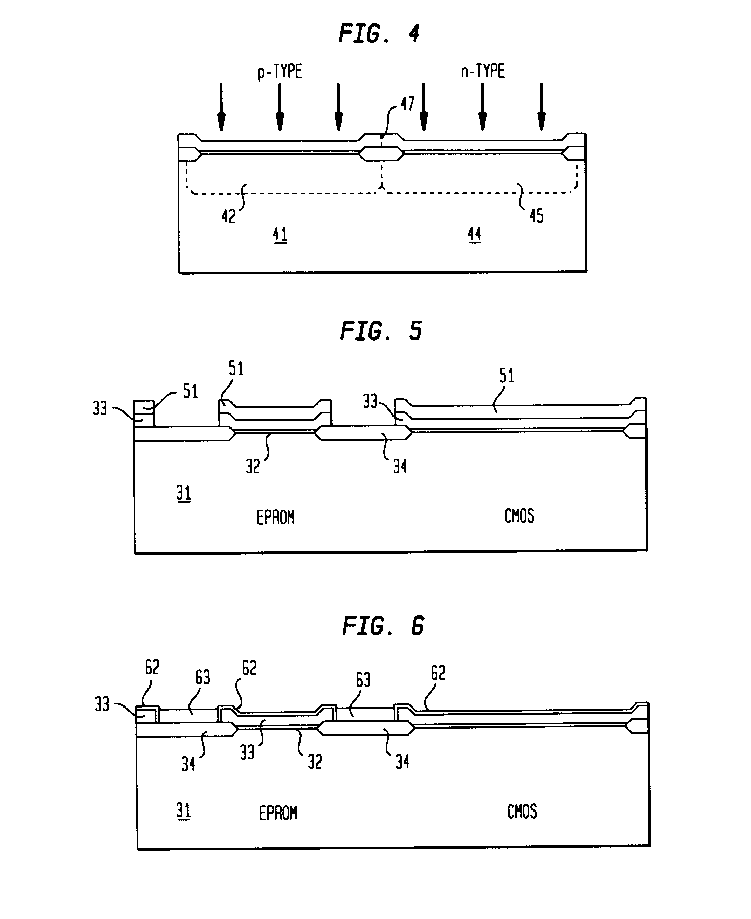

Figure 4 shows the structure of Figure 3 in the dimension normal to the plane Figure 3. It will be understood that the single device site shown in Figure 3 is but one of many in the overall integrated circuit. To better illustrate one aspect of the invention it is helpful to view at least two CMOS devices to illustrate the complementary doping of the CMOS devices. Thus Figure 4 is a view along the length of the gate area of Figure 3 and shows two complementary MOS devices with gates serially connected. The device indicated generally at 41 is destined to be a p-channel device with n-tub shown at 42 and p-doping, indicated by the arrows, for the portion of the polysilicon gate that serves device 41. Device 44 will be an n-channel device with p-tub shown at 45 and n-doping for those portions of the polysilicon level that form gates for n-channel devices. The first level poly in the EPROM region of the device ( not shown in Figure 4 ) that eventually forms the floating gates for the EPROMs is doped at this point with the same n-type implant. ( For p-type arrays the p-type implant is used. ) The p-n junction that forms between these doped regions is indicated at 47. The cladding layer that shunts this junction is usually deposited at this point in the process but according to this invention there are intervening steps that will now be described.

Referring to Figure 5, the processing departure that is a basis for this invention is shown. The primary departure is the formation of the interlevel dielectric layer 24 of Figure 2 selectively on the floating gates. Two approaches can be used. The dielectric can be grown or blanket deposited, then patterned to form the intergate dielectric while removing the dielectric from the entire CMOS area. The dielectric is preferably SiO₂ although other dielectric materials may be chosen. If SiO₂ is used the layer may be grown on the first poly layer. Alternatively the floating gate may be patterned prior to formation of the intergate dielectric. The latter option is illustrated in Figure 5 where the gate poly layer 33 is etched using lithographic mask 51. The etch method may be any of several known in the art. An anisotropic plasma etch is preferred to preserve the pattern dimensions. After the floating gate is defined the mask 51 is stripped and the intergate dielectric 62 is grown and/or deposited as shown in Figure 6.

An advantage of patterning the floating gates prior to forming the intergate oxide is that the sidewalls of the floating gate are defined and can be effectively covered during growth or deposition of the intergate oxide. It is preferred that at least part of the intergate oxide be grown to assure good sidewall coverage. A combination of thermal growth and TEOS can be used effectively. Depositing a relatively thick TEOS layer and planarizing by known plasma palanarization techniques has the advantage of filling at least part of the valley between adjacent floating gates thus planarizing the structure for later process steps. In Figure 6 the grown oxide layer covering the floating gate and the floating gate sidewalls is shown at 62 and the planarizing TEOS layer at 63.

It is preferable to maintain a high quality oxide surface for the intergate dielectric. Grown oxides are relatively defect free and, as already stated, are preferred. A technique for depositing a planarizing layer that covers the valleys between the floating gates while leaving the grown oxide layer relatively clean is described by A. T. Mitchell, et al, "A new self-aligned planar array cell for ultra high density EPROMs", *IEDM Tech. Dig.,* pp. 548-551, 1987.

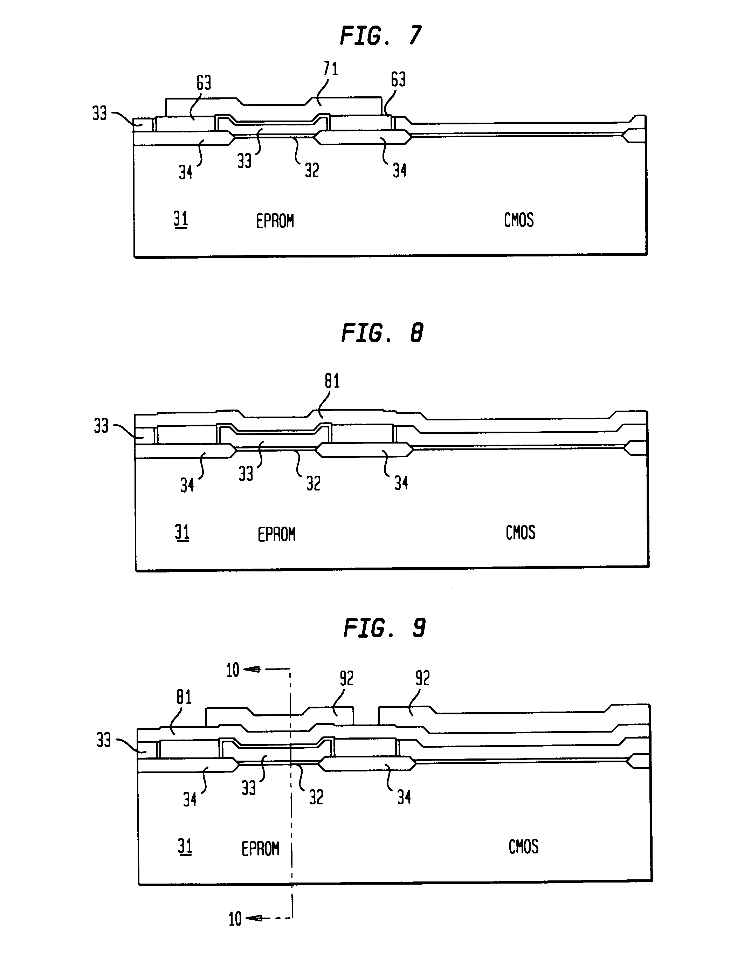

The next step, shown in Figure 7, is to remove the intergate dielectric from the CMOS devices. Lithographic mask 71 is selectively applied over the EPROM array and the exposed oxide 62 is removed with e.g. a plasma strip. The oxide layer is relatively thin and therefor can also be removed with a wet etch without risk of substantial undercutting.

Next the lithographic mask 71 is stripped and the exposed native oxide or other intergate dielectric is cleaned to preserve the quality of the interface on the EPROM side of the device. The cladding layer 81 is then deposited over the entire structure as indicated in Figure 8. The cladding layer is preferably TiN and may be deposited by known techniques, e.g. sputtering from a TiN cathode. The layer may be of the order of 100-1000nm in thickness. In the CMOS area the cladding layer is bonded to the gate polysilicon as in the conventional CMOS process. On the EPROM side, over the floating gates, it is bonded to the intergate dielectric to form the control gate for the EPROM.

Alternatively, the cladding layer may be selected from a variety of refractory metals, metal alloys and metallic compounds, e.g. silicides. Examples of such materials are tungsten, tantalum, titanium, chromium, tantalum nitride, cobalt silicide, tantalum silicide, titanium silicide. Salicide techniques may also be found useful in which the cladding layer over the EPROM intergate dielectric remains metal while the polysilicon CMOS gate is salicided.

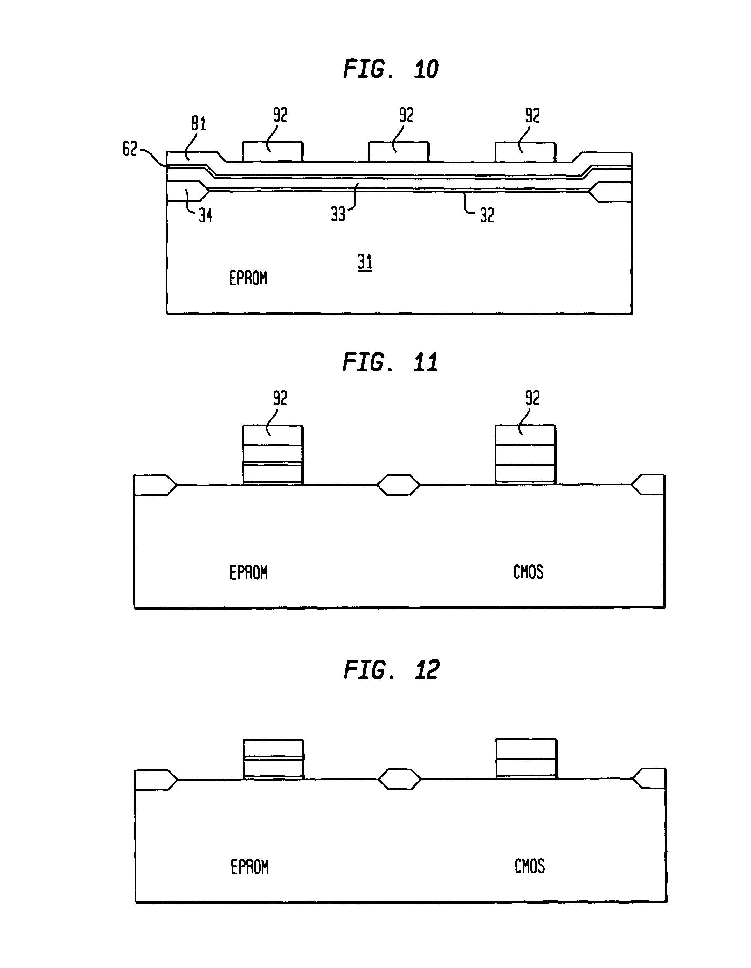

The structure shown in Figure 8 is then masked with lithographic mask 92 as shown in Figure 9. The view through the other x-z dimension, i.e. the section 10-10 shown in Figure 9, appears in Figure 10 where several floating gates of the EPROM array are seen. With the mask 92 in place the structure is then etched to reach the final gate stack geometry as shown in Figure 11. This etch typically defines the final gate dimensions and is relatively severe. Consequently it is preferred that the mask 92 be a hard oxide mask. Since the stack height difference between the EPROM side and the CMOS side is only a few hundred Angstroms or less both gate stacks can be etched simultaneously. The cladding layer is etched until endpoint detection shows it is clear in the CMOS area. A brief timed selective oxide etch will clear the intergate dielectric on the EPROM side. Thereafter the standard polysilicon etch of level one is used to produce the structure shown in Figure 12. Removal of the mask 92, an optional step, produces the gate stack structures shown in Figure 12. The relative stack height is evident as was shown in Figure 2.

The gate stack structure of Figures 11 and 12 shows the unmasked layers etched through to the substrate for source/drain implants into the bare silicon substrate. Alternatively, the gate oxide can be retained and the source/drain implants made through the gate oxide layer.

The remaining steps required to reach the structure of Figure 2, i.e. LDD implants, sidewall spacers, source/drain implants using the spacers as an implant mask, oxide deposition, contact hole formation, and metalization are standard operations that require no specific explanation.

Although it is not evident from the Figures the thickness of the polysilicon gate for the CMOS devices will be identical to the thickness of the floating gates in the ERPOM device array since they are derived from the same layer. The cladding layer thickness in the two gate stacks will be identical since they also are derived from the same layer. These device characteristics will easily reveal whether the foregoing process sequence was used in the manufacture of an integrated circuit.

Various additional modifications of this invention will occur to those skilled in the art. All deviations from the specific teachings of this specification that basically rely on the principles and their equivalents through which the art has been advanced are properly considered within the scope of the invention as described and claimed.

## Claims

1. An MOS integrated circuit comprising an array of EPROM devices and an array of CMOS devices, the CMOS devices having source, drain and control gate and the EPROM devices having source, drain, control ate and floating gate, the gate of the CMOS devices comprising a olysilicon gate layer and a cladding layer overlying the polysilicon gate layer, and the EPROM devices comprising a polysilicon floating gate ayer, an intergate dielectric layer overlying the polysilicon floating gate, and a control gate layer overlying the intergate dielectric layer, the nvention characterized in that the control gate layer of the EPROM evices and the cladding layer of the CMOS devices are of the samematerial and are derived from patterning the same deposited layer.

2. The integrated circuit of claim 1 wherein the intergate dielectric is SiO₂.

3. The integrated circuit of claim 1 wherein the cladding layer is selected from the group consisting of TiN, TaN, TiSi, CoSi, WSi, W, Ti, and Ta.

4. The integrated circuit of claim 3 wherein the cladding layer is TiN.

5. The integrated circuit of claim 3 further including sidewall spacers for both the CMOS gate and the EPROM floating gate and lightly doped source/drain adjacent both said gates.

6. The integrated circuit of claim 5 in which the polysilicon gates for the CMOS device array and the polysilicon floating gates for the EPROM device are derived from the same deposited layer.

7. The integrated circuit of claim 6 in which the thickness of the polysilicon gates in the CMOS array is identical to the thickness of the polysilicon gates in the EPROM array and said gates are derived from the same polysilicon layer.

8. The integrated circuit of claim 3 in which the thickness of the cladding layer on the devices in the CMOS array is identical to the thickness of the cladding layer on the EPROM devices and both said cladding layers are derived from the same deposited layer.

9. The integrated circuit of claim 3 in which the control gate of the CMOS devices and the floating gates of the EPROM devices are both polysilicon overlying an oxide gate dielectric, and the oxide gate dielectric is thinner than the said intergate dielectric of the EPROM devices.

10. The integrated circuit of claim 1 in wherein the polysilicon gate layer of the CMOS devices has a first region implanted with p-type impurities and a second region implanted with n-type impurities

11. Method for the manufacture of integrated circuits comprising the steps of:
a. growing a gate dielectric layer on a silicon substrate,
b. depositing a polysilicon layer over the gate dielectric layer;
c. doping a first region of the polysilicon layer with p-type impurities,
d. doping a second region of the polysilicon layer with n-type impurities,
e. masking said first and second polysilicon regions and portions of a third region of the polysilicon layer leaving portions of the third region of the polysilicon layer exposed,
f. removing the exposed portions of the third region to form a plurality of first polysilicon gate structures,
g. forming an intergate dielectric layer selectively over said firstpolysilicon gate structures,
h. depositing a cladding layer over said first and second polysilicon regions and over said intergate dielectric layer,
i. patterning said first and second regions to form a plurality of second gate structures.

12. The method of claim 11 in which the intergate dielectric layer is SiO₂.

13. The method of claim 12 in which at least a portion of the SiO₂ is grown from the polysilicon floating gate.

14. The method of claim 13 further including the step of depositing a planarizing oxide between said first gate structures prior to depositing said cladding layer.

15. The method of claim 11 in which the cladding layer is selected from the group consisting of TiN, TaN, TiSi, CoSi, WSi, W, Ti, and Ta.

16. The method of claim 15 in which the cladding layer is TiN.

17. The method of claim 15 in which the thickness of the cladding layer is in the range 100-300nm.

18. The method of claim 11 further including the steps of forming spacers on the sidewalls of the first and second gate structures and implanting impurities into the substrate using said spacers as a mask.
